# DEMANDE DE BREVET EUROPEEN

(11) **EP 1 133 010 A1**
(43) Date de publication de la demande: **12.09.2001**
(21) Numéro de dépôt: 01400535.9
(22) Date de dépôt: 01.03.2001
(51) Int. Cl.: H01R 12/22, H01R 43/16, H05K 13/04

(54) **Pièce de contact pour connecteur éléctrique**

(30) Priorité: 03.03.2000 FR 0002794
(71) Demandeur: Proner Comatel, 38530 Chapareillan (FR)
(72) Inventeur: Drouhot, Jérôme, 73160 Vimines (FR); Bonnet, Damien Gilles Henri Michel, 38100 Grenoble (FR); Arnoul, Francois Gilles, 94520 Perigny sur Yerres (FR)
(74) Mandataire: Laget, Jean-Loup

(57) **Abrégé**

Cette pièce de contact 1 pour connecteur électrique, fabriquée par découpage et pliage à partir d'un ruban 12 de métal conducteur, comporte une partie de contact femelle 2 apte à établir un contact électrique avec une partie du contact mâle d'un composant électrique ou électronique à connecter, et au moins deux, de préférence trois, pattes de connexion 3, 4 et 5 formées d'un seul tenant avec ladite partie de contact femelle et aptes à être posées et fixées sur des plages conductrices correspondantes d'une carte à circuit imprimé par une technique de brasage par refusion

L'une 3 des trois pattes de connexion 3, 4 et 5 a une surface plus grande que celle des autres pattes de connexion 4 et 5 pour servir à la fois d'élément de connexion électrique et d'élément de préhension pouvant être saisi par une pipette aspirante 25 d'une machine de report de composants.

## Description

La présente invention concerne une pièce de contact pour connecteur électrique, fabriquée par découpage et pliage à partir d'un ruban de métal conducteur, comportant une partie de contact femelle apte à établir un contact électrique avec un partie de contact mâle d'un composant électrique ou électronique à connecter, et au moins deux pattes de connexion formées d'un seul tenant avec ladite partie de contact femelle et aptes à être posées et fixées sur des plages conductrices correspondantes d'une carte à circuit imprimé par une technique de brasage par refusion.

Dans la fabrication des modules électriques et/ou électroniques du type comportant des composants électriques et/ou électroniques montés sur une carte à circuit imprimé, on utilise de plus en plus des composants à montage en surface, couramment appelés composants CMS. A cet effet, les composants CMS, munis de pattes de connexion appropriées, sont posés sur des plages conductrices sur la surface d'une carte à circuit imprimé, qui ont été préalablement revêtues d'une pâte à braser par une technique de sérigraphie, puis on fait passer la carte à circuit imprimé portant les composants CMS dans un four de refusion afin de souder les pattes de connexion des composants CMS à leur plages conductrices respectives sur la carte à circuit imprimé.

Cependant, certains composants électriques ou électroniques n'ont pas une tenue en température suffisante pour pouvoir résister à la température régnant dans le four de refusion. C'est pourquoi, on utilise habituellement dans ce cas des connecteurs électriques, réalisés eux mêmes en tant que composants CMS, qui sont fixés sur la carte à circuit imprimé par la technique de brasage par refusion et auxquels sont ensuite connectés les composants électriques ou électroniques qui supportent mal la température du four de refusion. Ces connecteurs électriques sont usuellement constitués d'un boîtier en matière isolante et de pièces de contact électrique femelles disposées dans des alvéoles du boîtier. Un tel connecteur électrique est par exemple décrit dans la demande de brevet en France N° 2 766 630.

Certains composants électroniques ou électriques, comme par exemple des petits moteurs pas à pas, ont des broches ou des languettes de connexion présentant un écart relativement important les unes par rapport aux autres. Il faut alors utiliser un connecteur dont le boîtier a un volume relativement important par rapport aux pièces de contact qu'il contient.

L'idée qui est à la base de la présente invention est de supprimer le boîtier du connecteur. Toutefois, dans ce cas, la difficulté réside alors dans la manipulation des pièces de contact, surtout si elles sont très petites, pour les poser et les fixer sur une carte à circuit imprimé. En effet, dans ce cas, les pièces de contact sont difficilement saisissables par les machines usuelles de report de composants.

La présente invention a donc pour but de faciliter la manipulation de pièces de contact, même très petites, et de faciliter leur pose individuellement sur une carte à circuit imprimé.

A cet effet, la présente invention a pour objet une pièce de contact du genre défini en préambule, caractérisée en ce que l'une des deux pattes de connexion a une surface plus grande que celle de l'autre patte de connexion pour servir à la fois d'élément de connexion électrique et d'élément de préhension pouvant être saisi par une pipette aspirante.

La pièce de contact selon l'invention peut en outre présenter une ou plusieurs des caractéristiques suivantes :
- ladite partie de contact femelle comporte une cage conductrice ayant au moins trois parois latérales rectangulaires, sensiblement planes, qui sont deux à deux perpendiculaires, deux desdites parois latérales, qui se font mutuellement face, portant chacune, sur un bord, une lamelle flexible de contact et, sur un bord opposé, une desdites pattes de connexion, chacune desdites pattes de connexion étant pliée en équerre vers l'extérieur par rapport à la paroi latérale correspondante.
- ladite cage conductrice comporte quatre parois latérales deux à deux opposées, dont une première paire de parois latérales opposées porte lesdites lamelles flexibles de contact et lesdites pattes de connexion, l'une des parois de la seconde paire de parois latérales opposées portant une autre patte de connexion pliée en équerre vers l'extérieur.

On obtient ainsi une pièce de contact qui peut être facilement saisie par sa patte de connexion la plus large, à l'aide d'une pipette aspirante, et qui, grâce à ses trois pattes de connexion, a une bonne stabilité lorsqu'elle est posée sur une carte à circuit imprimé.

L'invention a également pour objet un ensemble de pièces de contact comportant une succession de pièces de contact liées chacune par au moins une liaison fragilisée à au moins une bande de rive d'un ruban de métal conducteur ayant servi à leur fabrication, caractérisé en ce que chaque pièce de contact de ladite succession de pièces de contact est une pièce de contact présentant une ou plusieurs des caractéristiques susmentionnées.

Avantageusement, ladite succession de pièces de contact liées à la bande de rive est enroulée (par le fabricant de pièces de contact) sous la forme d'une bobine ou d'une galette, c'est-à-dire sous la forme d'une bobine plate dans laquelle le ruban conducteur portant la succession de pièces de contact est enroulé sur lui-même en spirale. La succession de pièces de contact enroulée sous la forme de bobine ou galette peut être ensuite livrée sous cette forme à un fabricant de modules électriques ou électroniques qui peut alors monter les pièces de contact sur une carte à circuit imprimé à l'aide d'une machine de report de composants.

L'invention a également pour objet un procédé de pose de pièces de contact en tant que composants à montage en surface sur une carte à circuit imprimé, caractérisé en ce qu'il consiste :
a) à installer un ensemble de pièces de contact sous forme de galette dans un magasin d'une machine de report de composants ;
b) à dérouler ladite galette installée dans ledit magasin ;
c) à faire passer les pièces de contact de la galette en cours de déroulement dans un guide vrillé en hélice sur un quart de tour, de façon à faire basculer lesdites pièces de contact de 90° par rapport à ladite bande de rive et, simultanément, à rompre la liaison fragilisée entre chaque pièce de contact ainsi basculée et la bande de rive, tout en amenant chaque pièce de contact ainsi séparée de la bande de rive à un poste de saisie de ladite machine de report de composants ;
d) à saisir, par sa patte de connexion la plus large, chaque pièce de contact arrivant audit poste de saisie, à l'aide d'une pipette aspirante de ladite machine ;
e) à amener chaque pièce de contact saisie par la pipette aspirante à un emplacement désiré sur la carte à circuit imprimé, et à déposer la pièce de contact audit emplacement désiré.

D'autres caractéristiques de l'invention ressortent de la description suivante d'un exemple de réalisation donné en référence aux dessins annexés sur lesquels :
- la figure 1 est une vue en perspective d'une pièce de contact selon l'invention ;
- la figure 2 est une vue de dessous de la pièce de contact de la figure 1 ;
- la figure 3 est une vue en perspective illustrant de manière schématique une machine de report de composants utilisable pour saisir et poser individuellement des pièces de contact selon l'invention sur une carte à circuit imprimé ;
- les figures 4 et 5 sont des vues partielles en perspective de la machine montrée sur la figure 3, respectivement suivant les flèches F1 et F2 de cette figure 3, montrant à plus grande échelle comment les pièces de contact sont détachées de leur ruban porteur et saisies individuellement par une pipette aspirante de ladite machine ; et
- la figure 6 est une vue partielle en perspective montrant une pièce de contact en cours de pose sur une carte à circuit imprimé par la pipette aspirante.

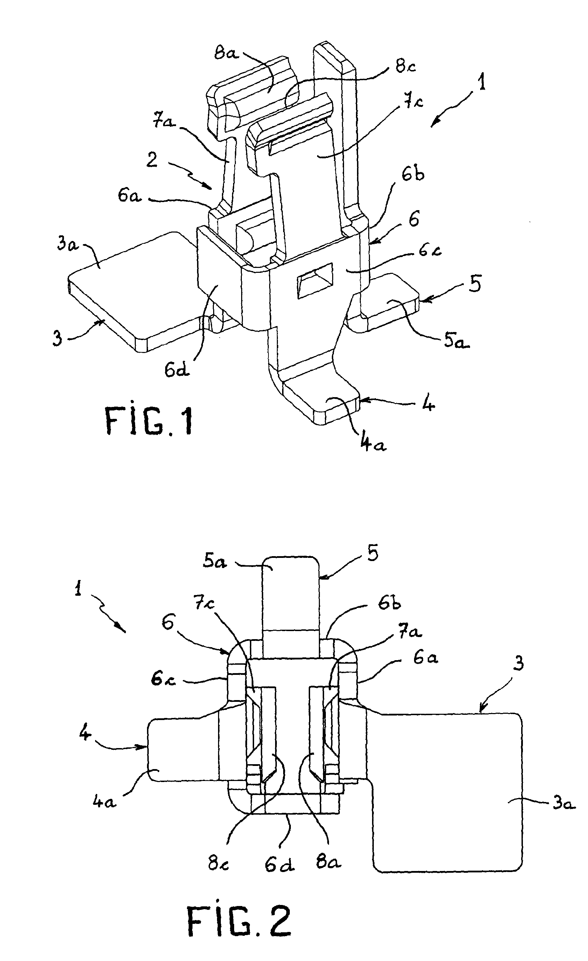

La pièce de contact 1 représentée dans les figures 1 et 2 comporte essentiellement une partie de contact femelle 2 et au moins deux pattes de connexion, de préférence trois pattes de connexion 3, 4 et 5 qui sont formées d'un seul tenant avec la partie de contact femelle 2.

La partie de contact femelle 2 comporte, de façon connue en soi, une cage conductrice 6, qui se compose d'au moins trois parois, de préférence quatre parois latérales 6a à 6d, qui ont une forme rectangulaire et sont planes ou sensiblement planes. Les parois 6a à 6d sont deux à deux perpendiculaires, les parois 6a et 6c étant parallèles et se faisant mutuellement face, de même que les parois 6b et 6d.

Chacune des deux parois 6a et 6c porte sur son bord supérieur, une lamelle flexible de contact 7a ou 7c qui est d'un seul tenant avec la paroi 6a ou 6c correspondante. Les deux lamelles 7a et 7c, vues dans la figure 1, s'étendent vers le haut à partir des parois 6a et 6c et sont légèrement inclinées l'une vers l'autre, de telle façon que leurs extrémités supérieures, qui peuvent présenter de façon connue des parties embouties 8a et 8c dirigées l'une vers l'autre, présentent un écartement prédéfini. Cet écartement prédéfini est plus faible que l'épaisseur d'une languette de contact mâle ou le diamètre d'une broche de contact mâle d'un composant électrique ou électronique, qui est destinée à être insérée dans la cage conductrice 6 de la pièce de contact femelle 1, afin d'établir un contact électrique avec ses lamelles de contact 7a et 7c.

Les trois pattes de connexion 3, 4 et 5 sont formées d'un seul tenant respectivement avec les trois parois 6a, 6b et 6c de la cage 6 et s'étendent vers le bas à partir du bord inférieur de la paroi correspondante de la cage 6. Comme cela est plus particulièrement visible dans la figure 1, chacune des pattes de connexion 3, 4 et 5 est pliée en équerre, vers l'extérieur par rapport à la paroi latérale 6a, 6b ou 6c correspondante de la cage 6, de façon à former à chaque fois un pied 3a, 4a ou 5a. Les trois pieds 3a, 4a et 5a sont situés dans un même plan horizontal, qui est perpendiculaire aux plans des parois latérales 6a à 6b de la cage 6 et qui est également perpendiculaire à la direction d'insertion de ladite languette ou broche de contact mâle sus-mentionnée dans la cage 6 entre les lamelles de contact 7a et 7c.

Conformément à la présente invention, l'un des trois pieds, par exemple le pied 3a a une surface sensiblement plus grande, par exemple environ quatre fois plus grande que celle des deux autres pieds 4a et 5a, de telle façon que le pied 3a puisse être saisi par une pipette aspirante standard d'une machine classique de report de composants. Dans un mode de réalisation typique de la pièce de contact selon l'invention, les deux pieds 4a et 5a ont par exemple, de façon connue, une surface d'environ 0,45 mm² tandis que le pied 3a a par exemple une surface de 1,6 mm², de façon à pouvoir être saisi par une pipette aspirante ayant un diamètre extérieur standard de 1,3 mm.

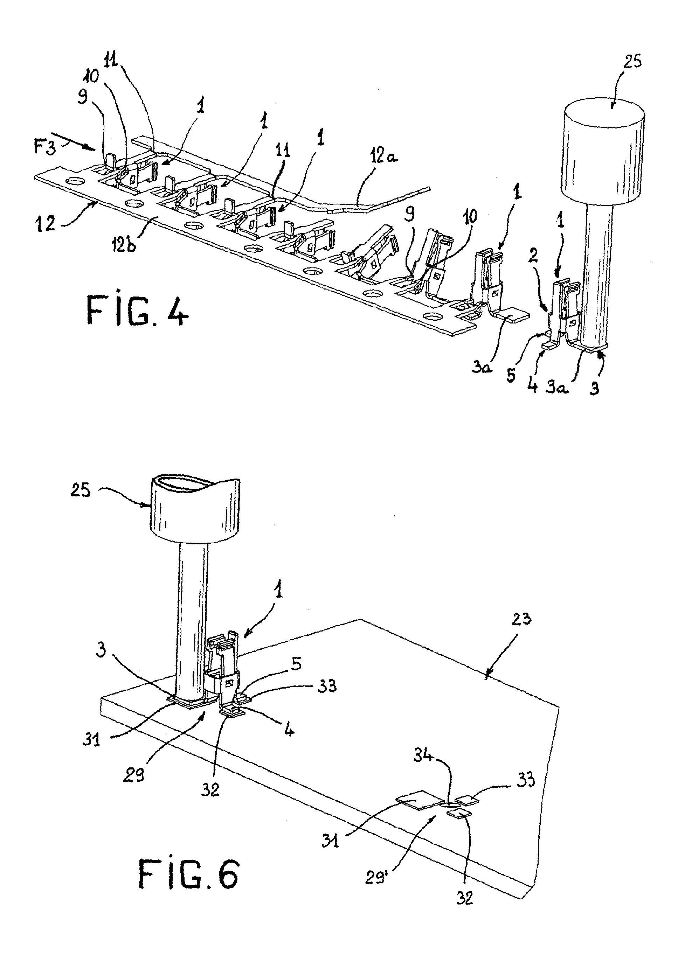

La pièce de contact 1 décrite ci-dessus peut être fabriquée, à partir d'un ruban de métal conducteur, par des opérations de découpage et de pliage effectuées à l'aide d'un outil à suivre de type conventionnel, mais utilisant ici un poinçon de découpage apte à réaliser une patte de connexion ayant un pied d'une superficie plus grande que celle du pied du ou des autres pattes de connexion. A la sortie de l'outil à suivre, on obtient de façon connue en soi une succession de pièces de contact 1 qui sont encore liées par de minces ponts de matière 9, 10, 11 (voir la figure 4) à au moins une bande de rive, de préférence deux bandes de rive 12a et 12b du ruban 12 de métal conducteur à partir duquel les pièces de contact 1 ont été fabriquées par découpage et pliage.

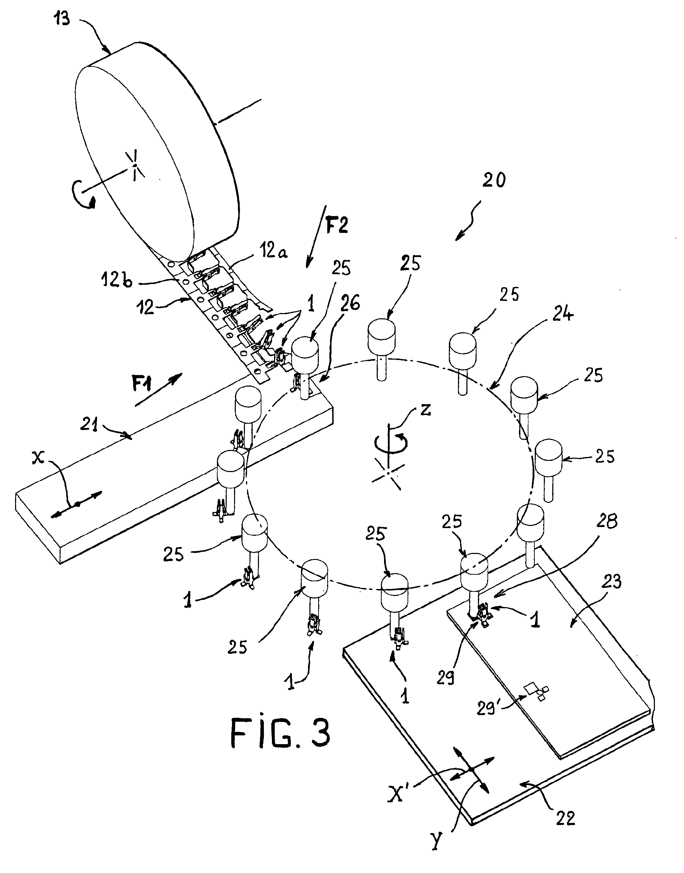

Cependant, à la différence des pièces de contact connues du même genre, comme par exemple celles décrites dans la demande de brevet FR 2 766 630 de la demanderesse, les pièces de contact 1 selon l'invention ne sont pas détachées du ruban 12 pour être placées respectivement dans des alvéoles du boîtier isolant d'un connecteur, mais le ruban 12 de métal conducteur portant les pièces de contact 1 est enroulé sous la forme d'une bobine plate ou galette 13 (voir la figure 3). La galette 13 peut être ultérieurement utilisée pour poser et fixer les pièces de contact 1 selon l'invention individuellement en tant que composant CMS sur une carte à circuit imprimé, à l'aide d'une machine de report de composants d'un type quelconque connu, comportant au moins une pipette aspirante pour saisir les composants et les poser sur une carte à circuit imprimé.

La figure 3 montre de manière schématique une machine de report de composants 20 utilisable avec des pièces de contact 1 selon l'invention. La machine 20 est une machine du type à magasin mobile et à plusieurs pipettes aspirantes, qui est couramment appelée "CHIP SHOOTER" par les hommes de l'art. Une telle machine permet habituellement de poser des composants CMS sur des cartes à circuit imprimé à une cadence d'environ 40.000 à 50.000 composants par heure.

La machine 20 représentée schématiquement sur la figure 3 comporte essentiellement :
a) un magasin 21, qui porte des composants à poser sur une carte à circuit imprimé et qui est mobile dans les deux sens dans une direction horizontale X;
b) une table de support 22, qui porte une carte à circuit imprimé 23 destinée à recevoir des composants en provenance du magasin 21, et qui est mobile dans les deux sens dans chacune des deux directions horizontales X', qui est parallèle à X, et Y qui est perpendiculaire à X' ; et
c) un barillet 24 (représenté schématiquement par un ovale en traits mixtes dans la figure 3), qui peut tourner rapidement pas à pas autour d'un axe vertical Z et qui porte, régulièrement espacées sur sa périphérie, plusieurs pipettes aspirantes 25.

Le magasin 21 porte de façon connue, sur un de ses deux côtés longitudinaux, plusieurs chargeurs (non-montrés) qui sont espacés le long dudit côté du magasin 21 et qui portent eux-mêmes chacun une galette telle que la galette 13 montrée dans la figure 3, chaque galette contenant elle-même des composants qui sont usuellement différents de ceux des autres galettes installées dans les chargeurs associés au magasin 21.

La direction de déplacement X du magasin 21 est tangentielle par rapport à la trajectoire circulaire des pipettes aspirantes 25 du barillet tournant 24. Chaque fois qu'il en reçoit l'ordre, le magasin 21 est déplacé dans la direction X d'une quantité appropriée pour amener le chargeur et la galette correspondante en face d'un poste de saisie 26. Le chargeur ainsi amené en face du poste de saisie est agencé, chaque fois qu'il en reçoit l'ordre, pour dérouler la galette correspondante, par exemple la galette 13, d'une quantité correspondant à un pas d'espacement des composants, par exemple des pièces de contact 1 qui sont portées par le ruban 12 formant la galette 13, afin d'amener un composant, par exemple une pièce de contact 1, au poste de saisie 26 où ce composant est saisi par l'une des pipettes aspirantes 25 de la machine 20.

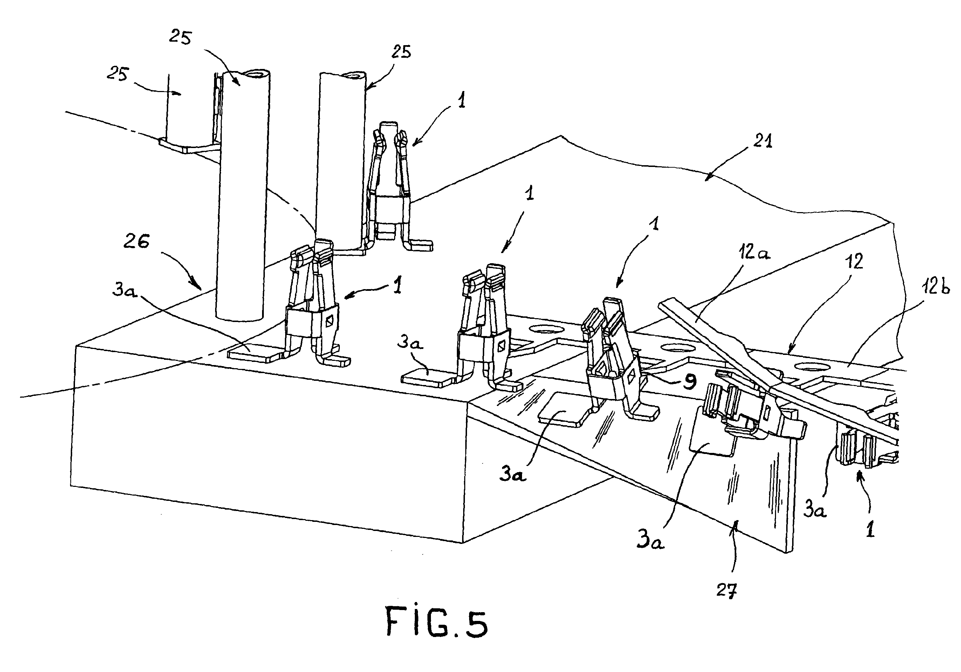

Dans le cas des pièces de contact 1 selon l'invention, qui occupent une position couchée horizontale dans le ruban 12 déroulé de la galette 13, chaque pièce de contact 1 doit être redressée verticalement et détachée du ruban 12 avant d'être saisie par l'une des pipettes aspirantes 25 de la machine, comme cela est illustré schématiquement par les figures 4 et 5. Par exemple, les liaisons fragilisées 11 peuvent être coupées au fur et à mesure que le ruban 12 avance dans le sens de la flèche F3 par des molettes de cisaillement (non-montrées) afin de séparer les pièces de contact 1 de la bande de rive 12a, cette dernière étant ensuite écartée du ruban 12, par un déviateur approprié non-montré, et évacuée. Lors de l'avance du ruban 12 dans le sens de la flèche F3, les pièces de contact 1 passent successivement dans un guide qui les fait basculer de 90° par rapport à la bande de rive 12b, afin de mettre les pièces de contact 1 en position verticale comme montré dans la figure 4 et 5. Comme cela est plus particulièrement visible dans la figure 5, le guide sus-mentionné peut être par exemple constitué par une rampe fixe 27, qui est vrillée en hélice sur un quart de tour et qui, au fur et à mesure de l'avance du ruban 12, agit sur les pieds 3a des pièces de contact 1 successives pour les redresser. La rupture des liaisons fragilisées 9 et 10 entre chaque pièce de contact 1 et la bande de rive 12b s'effectue automatiquement au cours du basculement de la pièce de contact 1 vers le haut, lorsque l'angle de basculement atteint une valeur de 45° ou plus.

A titre de variante, au lieu de faire passer les pièces de contact 1 sur la rampe 27, ou en plus de celle-ci, on pourrait faire passer les pièces de contact 1 entre deux rails de guidage parallèles, vrillées en hélice sur un quart de tour, agissant pas exemple sur les parois opposées 6b et 6d de la cage conductrice 6 de chaque pièce de contact 1 pour la faire basculer de 90° d'une manière semblable à celle décrite plus haut. Dans ce cas, les deux rails de guidage peuvent s'étendre pratiquement jusqu'au poste de saisie 26.

Afin que les pièces de contact 1 puissent atteindre en bon ordre le poste de saisie 26 après avoir été séparées de la bande de rive 12b du ruban 12, il est prévu des moyens d'entraînement non-montrés. Par exemple, ces moyens d'entraînement peuvent être constitués par une roue dentée ou par un système d'entraînement sans fin (vis sans fin ou convoyeur sans fin avec tocs d'entraînement), dont les dents, le filet ou les tocs d'entraînement agissent sur les pièces de contact 1 pour les maintenir avec un écartement approprié tout en les amenant jusqu'au poste de saisie 26.

Chaque pièce de contact 1 amenée au poste de saisie 26 est saisie à son tour par l'une des pipettes aspirantes 25 de la machine 20 et déplacée par cette pipette, par rotation du barillet 24 de la machine, jusqu'à un poste de pose 28 (figure 3) où la pièce de contact 1 saisie est déposée à l'emplacement désiré 29 de la carte à circuit imprimé 23 qui a été correctement positionnée au moyen de la table mobile 22 juste avant que ladite pipette et la pièce 1 qu'elle porte arrivent au poste 28.

La pièce de contact 1 suivante, qui est par exemple portée par la pipette aspirante 25 située juste derrière celle qui se trouve au poste 28 sur la figure 3, peut être déposée de manière similaire à un emplacement désiré 29' sur la carte à circuit imprimé 23, simplement en déplaçant la table mobile 22 de façon à amener l'emplacement 29' de la carte 3 au poste de pose 28, et en faisant tourner le barillet 24 d'un pas correspondant à l'espacement angulaire entre deux pipettes aspirantes 25 successives.

Comme montré dans la figure 6, à chaque emplacement 29 ou 29' destiné à recevoir une pièce de contact 1 selon l'invention, sur la carte à circuit imprimé 23, il est prévu trois plages de connexion 31, 32, et 33 respectivement pour les trois pattes de connexion 3, 4 et 5 de la pièce de contact amenée au poste de pose 28 par la pipette aspirante 25. A chaque emplacement 29, 29' destiné à recevoir une pièce de contact 1, il est également prévu un trou 34 dans la carte à circuit imprimé 23.

Bien entendu, avant que les différents composants CMS ne soient posés sur la carte à circuit imprimé 23, ses différentes plages de connexion, comme par exemple les plages 31, 32 et 33, et toutes les autres plages de connexion (non montrées) destinées à recevoir d'autres composants CMS, sont revêtues d'une pâte à braser. Après que tous les composants CMS désirés ont été installés sur la carte 23, celle-ci est passée dans un four de refusion (non-montré) afin de souder les différents composants CMS, y compris les pièces de contact 1, à leurs plages respectives de connexion.

Les composants électriques et/ou électroniques destinés à être connectés à la carte à circuit imprimé 23 par l'intermédiaire des pièces de contact 1 sont munis de languettes ou de broches de contact mâle qui peuvent être enfichées entre les lamelles flexibles 7a et 7c des pièces de contact 1 soit directement par en haut, soit par en dessous à travers les trous 34 de la carte à circuit imprimé.

Il est bien entendu que le mode de réalisation de l'invention qui a été décrit ci-dessus a été donné à titre d'exemple purement indicatif et nullement limitatif, et que de nombreuses modifications peuvent facilement être apportées par l'homme de l'art sans pour autant sortir du cadre de l'invention. C'est ainsi notamment, bien que les deux parois 6a et 6d de la cage conductrice 6 de la pièce de contact 1 aient chacune un bord libre, les deux parois 6a et 6d pourraient comporter des moyens d'accrochage permettant de les lier mécaniquement l'une à l'autre. Par exemple la paroi 6d pourrait porter sur son bord libre une patte de liaison en forme de T ou en forme de queue d'aronde, apte à venir s'engager dans une encoche appropriée prévue dans le bord libre de la paroi 6a lors des opérations de pliage de la pièce de contact 1. D'un autre côté, on pourrait éventuellement se passer de la paroi 6d, bien qu'il soit préférable qu'elle soit présente.

Par ailleurs, la partie de contact 2 de la pièce de contact 1 pourrait avoir une autre forme que celle représentée sur les figures 1 et 2. Par exemple, elle pourrait comporter des lamelles flexibles repliées en épingle à cheveux à l'intérieur de la cage conductrice 6.

## Revendications

1. Pièce de contact pour connecteur électrique, fabriquée par découpage et pliage à partir d'un ruban (12) de métal conducteur, comportant une partie de contact femelle (2) apte à établir un contact électrique avec une partie de contact mâle d'un composant électrique ou électronique à connecter, et au moins deux pattes de connexion (3, 4) formées d'un seul tenant avec ladite partie de contact femelle et aptes à être posées et fixées sur des plages conductrices correspondantes (31, 32) d'une carte à circuit imprimé (23) par une technique de brasage par refusion, **caractérisé en ce que** l'une (3) des deux pattes de connexion (3, 4) a une surface plus grande que celle de l'autre patte de connexion pour servir à la fois d'élément de connexion électrique et d'élément de préhension pouvant être saisi par une pipette aspirante (25).

2. Pièce de contact selon la revendication 1, **caractérisée en ce que** ladite partie de contact femelle (2) comporte une cage conductrice (6) ayant au moins trois parois (6a - 6c) latérales rectangulaires, sensiblement planes, qui sont deux à deux perpendiculaires, deux desdites parois latérales (6a - 6c), qui se font mutuellement face, portant chacune, sur un bord, une lamelle flexible de contact (7a,7c) et, sur un bord opposé, une desdites pattes de connexion (3, 4), chacune desdites pattes de connexion étant pliée en équerre vers l'extérieur par rapport à la paroi latérale correspondante.

3. Pièce de contact selon la revendication 2, **caractérisée en ce que** ladite cage conductrice (6) comporte quatre parois latérales (6a - 6d) deux à deux opposées, dont une première paire de parois latérales opposée (6a et 6c) porte lesdites lamelles flexibles de contact (7a, 7c) et lesdites pattes de connexion (3, 4), l'une (6b) des parois de la seconde paire de parois latérales opposées (6b, 6d) portant une autre patte de connexion (5) pliée en équerre vers l'extérieur.

4. Ensemble de pièces de contact, comportant une succession de pièces de contact (1) liées chacune par au moins une liaison fragilisée (9, 10) à au moins une bande de rive (12b) d'un ruban (12) de métal conducteur ayant servi à leur fabrication, **caractérisé en ce que** chaque pièce de contact (1) de ladite succession de pièces de contact est une pièce de contact selon l'une quelconque des revendications 1 à 3.

5. Ensemble de pièces de contact selon la revendication 4, **caractérisé en ce que** ladite succession de pièces de contact (1) liées à la bande de rive (12b) est enroulée sous la forme d'une bobine ou galette (13).

6. Procédé de pose de pièces de contact en tant que composants à montage en surface sur une carte à circuit imprimé (23), **caractérisé en ce qu**'il consiste :
a) à installer un ensemble de pièces de contact (1) sous forme de galette (13) selon la revendication 5, dans un magasin (21) d'une machine de report de composants (20) ;
b) à dérouler ladite galette (23) installée dans ledit magasin (21) ;
c) à faire passer les pièces de contact (1) de la galette (13) en cours de déroulement dans un guide (27) vrillé en hélice sur un quart de tour, de façon à faire basculer lesdites pièces de contact (1) de 90° par rapport à ladite bande de rive (12b) et, simultanément, à rompre la liaison fragilisée (9, 10) entre chaque pièce de contact ainsi basculée et la bande de rive, tout en amenant chaque pièce de contact ainsi séparée de la bande de rive à un poste de saisie (28) de ladite machine de report de composants (20) ;
d) à saisir, par sa patte de connexion (3a) la plus large, chaque pièce de contact (1) arrivant audit poste de saisie (28), à l'aide d'une pipette aspirante (25) de ladite machine ;
e) à amener chaque pièce de contact (1) saisie par la pipette aspirante (25) à un emplacement désiré (29) sur la carte à circuit imprimé (23), et à déposer la pièce de contact audit emplacement désiré.
